# EUROPÄISCHE PATENTSCHRIFT

(11) **EP 3 061 186 B1**
(45) Veröffentlichungstag und Bekanntmachung des Hinweises auf die Patenterteilung: **03.04.2019**
(21) Anmeldenummer: 14786662.8
(22) Anmeldetag: 17.10.2014
(51) Int. Cl.: H03K 17/082, H03K 17/30

(54) **HALBBRÜCKE FÜR EINEN AKTIVEN GLEICHRICHTER**
HALF-BRIDGE FOR AN ACTIVE RECTIFIER
DEMI-PONT POUR REDRESSEUR ACTIF

(30) Priorität: 21.10.2013 DE 102013221322
(43) Veröffentlichungstag der Anmeldung: 31.08.2016
(73) Patentinhaber: SEG Automotive Germany GmbH, 70499 Stuttgart (DE)
(72) Erfinder: MEHRINGER, Paul, 70569 Stuttgart (DE); KOSZNAI, Zoltan, H-1221 Budapest (HU); ROSE, Petra, 72070 Tuebingen (DE); BALAZS, Zoltan, H-1096 Budapest (HU)
(74) Vertreter: Steinbauer, Florian
(86) Internationale Anmeldenummer: PCT/EP2014/072365
(87) Internationale Veröffentlichungsnummer: WO 2015/059059

(56) Entgegenhaltungen:
- DE-A1-102007 060 219
- DE-A1-102011 051 447
- US-A1- 2011 199 799
- ZHONG W X ET AL: "Generalized self-driven AC-DC synchronous rectification techniques for single- & multiphase systems", 2010 INTERNATIONAL POWER ELECTRONICS CONFERENCE : IPEC-SAPPORO 2010 - [ECCE ASIA] ; SAPPORO, JAPAN, IEEE, PISCATAWAY, NJ, USA, 21. Juni 2010 (2010-06-21), Seiten 2098-2105, XP031729009, ISBN: 978-1-4244-5394-8

## Beschreibung

Die vorliegende Erfindung betrifft eine Halbbrücke für einen aktiven Gleichrichter, insbesondere mit einem Überspannungsschutz.

### Stand der Technik

Zur Speisung von Gleichstromsystemen aus Drehstromsystemen können Gleichrichter unterschiedlicher Bauart eingesetzt werden. Die vorliegende Anmeldung betrifft dabei aktive bzw. gesteuerte Brückengleichrichter, die aktive Schaltelemente, beispielsweise in Form von bekannten Metall-Oxid-Halbleiter-Feldeffekttransistoren (MOSFETs) aufweisen. In Kraftfahrzeugbordnetzen werden in Entsprechung zu den dort üblicherweise verbauten Drehstromgeneratoren häufig Brückengleichrichter in sechspulsiger Ausführung verwendet. Die Erfindung eignet sich jedoch in gleicher Weise für Brückengleichrichter für andere Phasenzahlen, z.B. für fünfphasige Generatoren, und in anderen Einsatzszenarien.

Wie beispielsweise in der DE 10 2009 046 955 A1 erläutert, ist der Einsatz von aktiven Brückengleichrichtern in Kraftfahrzeugen unter anderem deshalb wünschenswert, weil diese im Gegensatz zu passiven bzw. ungesteuerten Brückengleichrichtern geringere Verlustleistungen aufweisen.

Ein aktiver Brückengleichrichter nach dem Stand der Technik ist in DE102007060219 A1 enthüllt.

Ein kritischer Fehlerfall insbesondere bei aktiven Brückengleichrichtern ist jedoch der Lastabwurf (engl. Load Dump). Dieser tritt dann auf, wenn sich bei hoch erregtem Generator und einem entsprechend hohen abgegebenen Strom die Last am Generator (z.B. durch Abschalten von Verbrauchern) schlagartig verringert und dies nicht durch kapazitiv wirkende Elemente im Gleichspannungsnetz (z.B. die Batterie im Kraftfahrzeugbordnetz) abgefangen wird.

Hierbei kann durch den Generator im Extremfall bis zu einer Dauer von ca. 300 bis 500 ms weiterhin Energie ins Netz geliefert werden. Diese muss im Brückengleichrichter umgesetzt (gelöscht) werden können, um nachgeschaltete elektrische Komponenten vor Überspannungsschäden zu schützen. Dieser Schutz erfolgt bei passiven bzw. ungesteuerten Brückengleichrichtern in der Regel durch die Gleichrichterdioden selbst, weil dort die Verlustenergie in Wärme umgesetzt werden kann. In derzeit erhältlichen aktiven Schaltelementen, beispielsweise MOSFETs, lassen sich diese Eigenschaften jedoch nicht vollständig nachbilden. Daher sind zusätzliche Schutzstrategien erforderlich.

Bei einem Lastabwurf können beispielsweise einige oder alle Phasen durch Ansteuerung der zugehörigen Schaltelemente mit Masse (also Lowside) kurzgeschlossen werden. Der sich dadurch ergebende Spannungseinbruch kann jedoch dazu führen, dass die Energieversorgung zur Ansteuerung der Schaltelemente nicht mehr bereitgestellt werden kann. Insbesondere können dazu verwendete BootStrap-Kondensatoren insbesondere im LowSide-Pfad nicht mehr nachgeladen werden.

Es ist daher wünschenswert, eine Möglichkeit anzugeben, so dass ein aktiver Gleichrichter mit einem Überspannungsschutz auch nach dem Schalten eines Kurzschlusses noch funktioniert.

### Offenbarung der Erfindung

Erfindungsgemäß wird eine Halbbrücke mit den Merkmalen des Patentanspruchs 1 vorgeschlagen. Vorteilhafte Ausgestaltungen sind Gegenstand der Unteransprüche sowie der nachfolgenden Beschreibung.

### Vorteile der Erfindung

Eine erfindungsgemäße Halbbrücke für einen aktiven Gleichrichter umfasst ein erstes ansteuerbares Schaltelement, über das ein Wechselspannungsanschluss der Halbbrücke mit einem Masseanschluss der Halbbrücke verbunden ist (LowSide-Pfad), sowie ein erstes Ansteuerelement zum Ansteuern des ersten Schaltelements. Ein für eine Spannungsversorgung des ersten Ansteuerelements verwendeter erster Kondensator wird vorteilhafterweise über einen positiven Gleichspannungsanschluss der Halbbrücke gespeist. Dadurch ist eine Spannungsversorgung gewährleistest, auch wenn durch das erste Schaltelement aktiv ein Kurzschluss zwischen dem Wechselspannungsanschluss und dem Masseanschluss hergestellt wird.

Es ist weiter von Vorteil, wenn die Halbbrücke ein zweites ansteuerbares Schaltelement, über das der Wechselspannungsanschluss mit dem positiven Gleichspannungsanschluss verbunden ist, sowie ein zweites Ansteuerelement zum Ansteuern des zweiten Schaltelements aufweist. Ein für eine Spannungsversorgung des zweiten Ansteuerelements verwendeter zweiter Kondensator wird ebenfalls vorteilhaft von dem positiven Gleichspannungsanschluss gespeist. Dadurch wird auch eine Spannungsversorgung für den zweiten Kondensator gewährleistet und im Kurzschlussfall nicht eingeschränkt.

Vorzugsweise weist eine Halbbrücke weiterhin ein drittes Ansteuerelement auf, das das erste Schaltelement im Falle einer Überspannung zwischen dem positiven Gleichspannungsanschluss und dem Masseanschluss schließt (sog. aktiver Kurzschluss), wobei das dritte Ansteuerelement vorzugsweise ebenfalls von dem ersten Kondensator für das erste Ansteuerelement versorgt wird. Auf diese Weise ist auch nach der Schaltung eines aktiven Kurzschlusses zum Schutz des aktiven Gleichrichters vor Überspannung die Spannungsversorgung für den ersten Kondensator gewährleistet. Die Funktionalität des aktiven Gleichrichters ist dadurch weiterhin gegeben.

Bei der Schaltung des aktiven Kurzschlusses kann es aufgrund eines Stromabfalls an dem Wechselspannungsanschluss zu einem Spannungseinbruch an dem positiven Gleichspannungsanschluss kommen. Da eine Auslösung des aktiven Kurzschlusses über das dritte Ansteuerelement erfolgt, ist gerade in diesem Zeitpunkt die Gewährleistung der Spannungsversorgung des dritten Ansteuerelements von hoher Bedeutung, da ansonsten die Ansteuerung des ersten Schaltelements und damit die die Aufrechterhaltung des aktiven Kurzschlusses nicht gewährleistet werden kann. Durch eine erste Diode, über welche in Durchlassrichtung der positive Gleichspannungsanschluss mit dem Anschluss des ersten Kondensators verbunden ist, wird der erste Kondensator von dem Spannungseinbruch an dem positiven Gleichspannungsanschluss entkoppelt. Dadurch kann aber gewährleistet werden, dass auch bei einem kurzen Spannungseinbruch an dem positiven Gleichspannungsanschluss die Spannungsversorgung des dritten Ansteuerelements gegeben ist.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

### Kurze Beschreibung der Zeichnungen

Figur 1 zeigt schematisch eine Halbbrücke eines aktiven Gleichrichters mit einem Überspannungsschutz (nicht erfindungsgemäß).
Figur 2 zeigt schematisch eine Halbbrücke eines aktiven Gleichrichters mit einem Überspannungsschutz in einer bevorzugten Ausgestaltung einer erfindungsgemäßen Anordnung.
Figur 3 zeigt schematisch einen typischen Aufbau eines Load-Dump-Tests in einem Bordnetz.
Figur 4 zeigt schematisch einen typischen Verlauf einer Spannung an einem positiven Gleichspannungsanschluss eines aktiven Gleichrichters mit Halbbrücken gemäß einer bevorzugten Ausgestaltung der Erfindung bei einem Load-Dump.

### Ausführungsform(en) der Erfindung

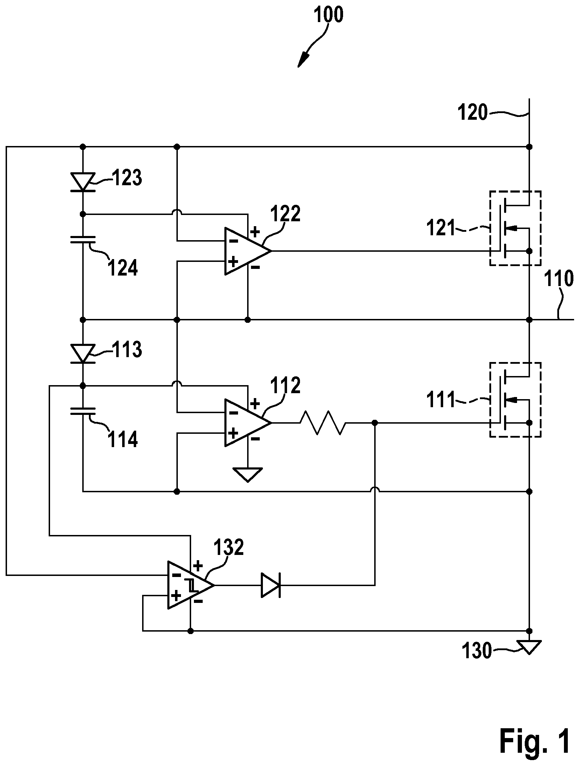

In Figur 1 ist schematisch eine nicht erfindungsgemäße Schaltung für eine Halbbrücke 100 eines aktiven Gleichrichters mit einem Überspannungsschutz dargestellt. Die Halbbrücke 100 umfasst einen Wechselspannungsanschluss 110, einen positiven Gleichspannungsanschluss 120 sowie einen Masseanschluss 130.

Über ein erstes Schaltelement 111, bspw. einen MOSFET, ist der Wechselspannungsanschluss 110 mit dem Masseanschluss 130 verbunden (LowSide). Über ein zweites Schaltelement 121, bspw. ebenfalls ein MOSFET, ist der Wechselspannungsanschluss 110 mit dem positiven Gleichspannungsanschluss 120 verbunden (HighSide).

Das erste Schaltelement 111 wird von einem ersten Ansteuerelement 112, bspw. einem Verstärker, gesteuert. Eine Spannungsversorgung für das erste Ansteuerelement 112 bildet ein erster Kondensator 114, der mit dem ersten Ansteuerelement 112 verbunden ist, zusammen mit einem Anschluss an Masse (Bootstrap-Prinzip). Der erste Kondensator 114 ist über eine erste Diode 113 mit dem Wechselspannungsanschluss 110 verbunden, worüber der erste Kondensator 114 gespeist wird. Die erste Diode 113 ist so geschaltet, dass nur eine Stromrichtung vom Wechselspannungsanschluss 110 zum ersten Kondensator 114 möglich ist. Auf der anderen Seite hat der erste Kondensator einen Anschluss an Masse.

Das zweite Schaltelement 121 wird von einem zweiten Ansteuerelement 122, bspw. ebenfalls einem Verstärker, gesteuert. Eine Spannungsversorgung für das zweite Ansteuerelement 122 bildet ein zweiter Kondensator 124, der mit der zweiten Ansteuerung 122 verbunden ist, zusammen mit einem Anschluss an den Wechselspannungsanschluss 110. Der zweite Kondensator 124 ist über eine zweite Diode 123 mit dem positiven Gleichspannungsanschluss 120 verbunden, worüber der erste Kondensator 114 gespeist wird. Die zweite Diode 113 ist so geschaltet, dass nur eine Stromrichtung vom positiven Gleichspannungsanschluss 120 zum zweiten Kondensator 124 möglich ist. Auf der anderen Seite ist der zweite Kondensator mit dem Wechselspannungsanschluss 110 verbunden.

Diese Art der Verschaltung ermöglicht eine Synchrongleichrichtung, d.h. die Schaltelemente schalten im Wesentlichen synchron mit einem Polaritätswechsel der Wechselspannung. Um einen unerwünschten Kurzschluss (d.h. beide Schaltelemente sind leitend) zu vermeiden, ist eine Induktivität am Ausgang des ersten Ansteuerelements 112 angeschlossen, die zu einem verzögerten Schalten des ersten Schaltelements 111 führt.

Zusätzlich verfügt die Halbbrücke 100 über ein drittes Ansteuerelement 132, bspw. ein Hystereseelement (d.h. Einschalt- und Ausschaltschwellen sind unterschiedlich). Das dritte Ansteuerelement 132 misst eine Spannung zwischen dem positiven Gleichspannungsanschluss 120 und dem Masseanschluss 130, womit Messeingänge der dritten Ansteuerung 132 jeweils verbunden sind. Eine Spannungsversorgung für das dritte Ansteuerelement 132 erfolgt über den ersten Kondensator 114, zusammen mit einem Anschluss an Masse. Das dritte Ansteuerelement 132 schließt das erste Schaltelement 111, wenn die Spannung zwischen dem positiven Gleichspannungsanschluss 120 und dem Masseanschluss 130 einen oberen Schwellwert (Einschaltschwelle) übersteigt.

Damit wird ein aktiver Kurzschluss vom Wechselspannungsanschluss 110 zum Masseanschluss 130 erzeugt, während der Wechselspannungsanschluss 110 auch mit dem positiven Gleichspannungsanschluss 120 verbunden sein kann. Dadurch wird eine Überspannung an dem Gleichspannungsanschluss 110, wodurch ein möglicher Verbraucher zu Schaden kommen könnte, abgebaut.

Dies hat jedoch zur Folge, dass dadurch der erste Kondensator 114 nicht mehr vom Wechselspannungsanschluss 110 gespeist wird, da dieser kurzgeschlossen ist. Somit kann im Folgenden das erste Schaltelement 111 nicht mehr angesteuert werden, da das erste Ansteuerelement nicht mehr vom ersten Kondensator mit Spannung versorgt werden kann. Die Halbbrücke 100 funktioniert nicht mehr.

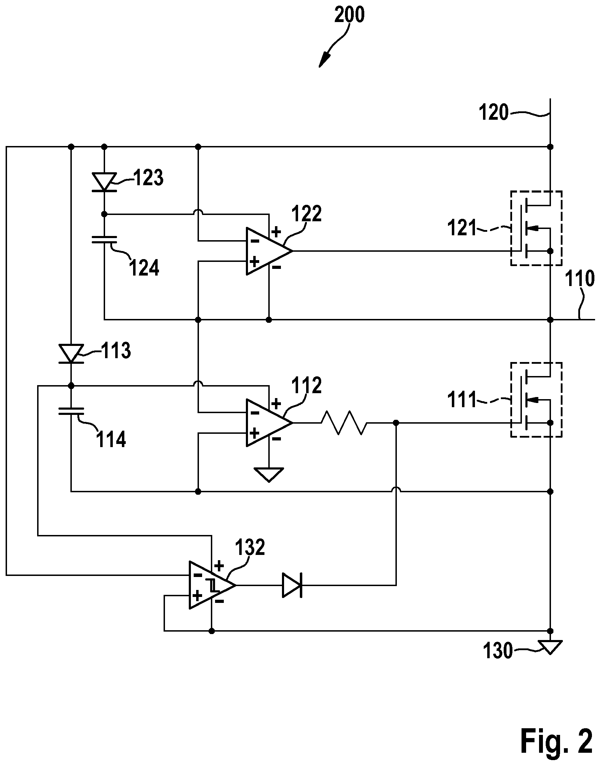

Zur Behebung dieses Problems schlägt die Erfindung eine alternative Verschaltung des ersten Kondensators 114 vor, wie in Figur 2 dargestellt. Dort ist schematisch eine Halbbrücke 200 eines aktiven Gleichrichters mit einem Überspannungsschutz in einer bevorzugten Ausgestaltung einer erfindungsgemäßen Anordnung dargestellt. Die Schaltung umfasst die gleichen Elemente wie die Schaltung in Figur 1, daher haben im Folgenden die Elemente die gleichen Bezugszeichen.

Im Unterschied zur Ausgestaltung gemäß Figur 1 ist bei der Halbbrücke 200 jedoch der erste Kondensator 114 über die erste Diode 113 mit dem positiven Gleichspannungsanschluss 120 verbunden, worüber der erste Kondensator 114 gespeist wird. Die erste Diode 113 ist so geschaltet, dass nur eine Stromrichtung vom positiven Gleichspannungsanschluss 120 zum ersten Kondensator 114 möglich ist. Auf der anderen Seite hat der erste Kondensator einen Anschluss an Masse. Insbesondere ist dadurch die Reihenschaltung aus der ersten Diode 113 und dem ersten Kondensator 114 mit einer Reihenschaltung des ersten Schaltelements 111 und des zweiten Schaltelements 121 parallel geschaltet, wohingegen sie bei der Ausführungsform gemäß Figur 1 nur mit dem ersten Schaltelement 111 parallel geschaltet ist, so dass dort durch Schließen des ersten Schaltelements 111 ein Laden des ersten Kondensators unterbunden wird.

Wird nun durch das dritte Ansteuerelement 132 im Überspannungsfall ein aktiver Kurzschluss vom Wechselspannungsanschluss 110 zum Masseanschluss 130 erzeugt, während der Wechselspannungsanschluss 110 auch mit dem Gleichspannungsanschluss 120 verbunden ist, wird der erste Kondensator 114 weiterhin über den Gleichspannungsanschluss 120 (und damit aus dem Borspannungsnetz) gespeist. Eine Spannungsversorgung des ersten Schaltelements 112 und somit die Funktion der Halbbrücke 200 ist dadurch auch weiterhin gewährleistet.

Das dritte Ansteuerelement 132 öffnet das erste Schaltelement 111 wieder, wenn die Spannung zwischen dem positiven Gleichspannungsanschluss 120 und dem Masseanschluss 130 einen unteren Schwellwert (Ausschaltschwelle) unterschreitet.

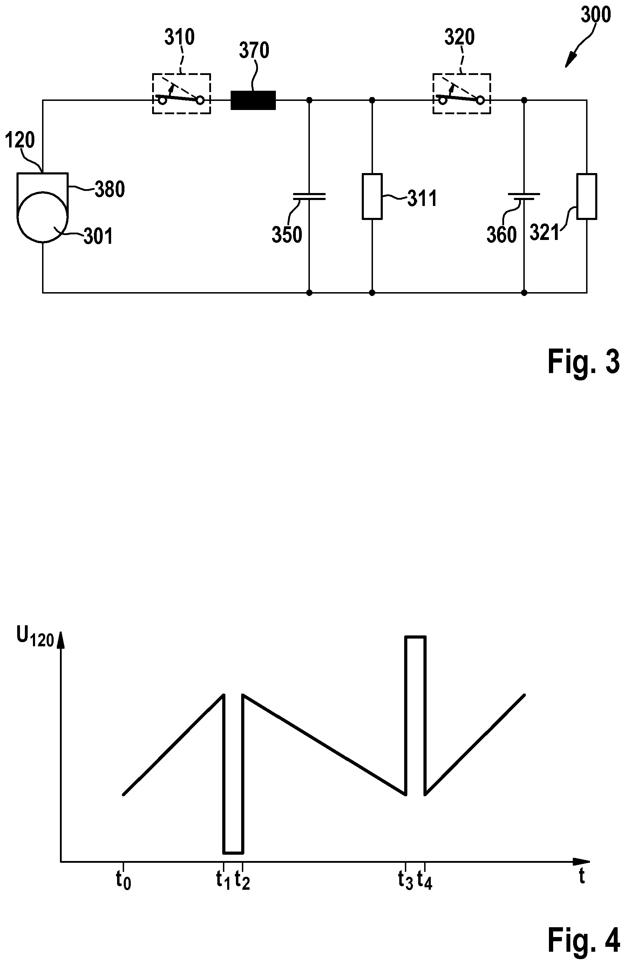

Bei der Schaltung des aktiven Kurzschlusses kann es aufgrund eines Stromabfalls an dem Wechselspannungsanschluss 110 oder aufgrund einer Bordnetzinduktivität (siehe Figuren 3 und 4) zu einem Spannungseinbruch an dem positiven Gleichspannungsanschluss 120 kommen. Da eine Auslösung des aktiven Kurzschlusses über das dritte Ansteuerelement 132 erfolgt, ist gerade in diesem Zeitpunkt die Gewährleistung der Spannungsversorgung des dritten Ansteuerelements 132 von hoher Bedeutung, da ansonsten die Ansteuerung des ersten Schaltelements 111 und damit die Aufrechterhaltung des aktiven Kurzschlusses nicht gewährleistet werden kann. Durch die erste Diode 113 wird der erste Kondensator 114 von dem Spannungseinbruch an dem positiven Gleichspannungsanschluss 120 entkoppelt. Dadurch kann gewährleistet werden, dass auch bei einem kurzen Spannungseinbruch an dem positiven Gleichspannungsanschluss 120 die Spannungsversorgung des dritten Ansteuerelements 132 gegeben ist. Bei einer Dimensionierung des Ansteuerelements 132 ist sinnvollerweise auf eine Kapazität zu achten, die die Spannungsversorgung während des Spannungseinbruchs sicherstellt.

In Figur 3 ist schematisch ein Bordnetz 300, bspw. eines Fahrzeugs, gezeigt, das einen Generator 301 mit einem synchronen aktiven Gleichrichter 380, welcher mehrere Halbbrücken gemäß der vorliegenden Erfindung, wie bspw. in Figur 2 dargestellt, umfasst, aufweist. Der positive Gleichspannungsanschluss 120 ist ebenfalls dargestellt.

Das Bordnetz 300 umfasst einen Energiespeicher 360, bspw. eine Fahrzeugbatterie, sowie zwei Verbraucher 311 und 321. Eine Induktivität der Komponenten (z.B. Leitungen) des Bordnetzes ist mit 370, eine Kapazität mit 350 bezeichnet. Weiterhin umfasst die Anordnung 300 zwei Schalter 310 und 320, mit denen eine elektrische Verbindung der beiden Verbraucher zum synchronen aktiven Gleichrichter 380 hergestellt oder getrennt werden kann.

Ein Öffnen des Schalters 320 bspw. trennt den Verbraucher 321 und die Batterie 360 zur Durchführung eines Load-Dump-Tests vom positiven Gleichspannungsanschluss 120. Dadurch steigt die Spannung U₁₂₀ am positiven Gleichspannungsanschluss 120 an. Dies ist in Figur 4 grob schematisch beginnend bei t₀ gezeigt.

Bei Überschreiten des oberen Schwellwerts wird der aktive Kurzschlusses geschaltet. Dies ist in Figur 4 grob schematisch bei t₁ gezeigt. Aufgrund der Bordnetzinduktivität kommt es zu einer Induktionsspitze, bis bei t₂ die Induktivität gelöscht ist. Daraufhin entspricht die Spannung U₁₂₀ am positiven Gleichspannungsanschluss 120 wieder der Bordnetzspannung, die im Wesentlichen von der Bordnetzkapazität 350 bestimmt wird.

Diese entlädt sich nun, bis bei t₃ der untere Schwellwert unterschritten und dementsprechend der aktive Kurzschluss wieder aufgehoben wird. Aufgrund der Bordnetzinduktivität kommt es wieder zu einer Induktionsspitze, bis bei t₄ die Induktivität gelöscht ist usw.

## Patentansprüche

1. Halbbrücke für einen aktiven Gleichrichter mit einem Wechselspannungsanschluss (110), einem positiven Gleichspannungsanschluss (120) sowie einem Masseanschluss (130),
wobei ein erstes Schaltelement (111) den Wechselspannungsanschluss (110) mit dem Masseanschluss (130) verbindet;
wobei ein zweites Schaltelement (121) den Wechselspannungsanschluss (110) mit dem positiven Gleichspannungsanschluss (120) verbindet,
wobei ein erstes Ansteuerelement (112) zum Schalten des ersten Schaltelements (111) mit dem ersten Schaltelement (111) verbunden ist;
wobei ein Anschluss eines ersten Kondensators (114) mit einem Spannungsversorgungsanschluss des ersten Ansteuerelements (112) verbunden ist; **dadurch gekennzeichnet, dass** der positive Gleichspannungsanschluss (120) über eine erste Diode (113) in Durchlassrichtung mit dem Anschluss des ersten Kondensators (114) verbunden ist;
wobei die Reihenschaltung aus dem ersten Kondensator (114) und der ersten Diode (113) mit der Reihenschaltung des ersten Schaltelements (111) und des zweiten Schaltelements (121) parallel geschaltet ist.

2. Halbbrücke nach Anspruch 1, wobei ein zweites Ansteuerelement (122) zum Schalten des zweiten Schaltelements (121) mit dem zweiten Schaltelement (121) verbunden ist; wobei ein Anschluss eines zweiten Kondensators (124) mit einem Spannungsversorgungsanschluss des zweiten Ansteuerelements (122) verbunden ist; wobei der positive Gleichspannungsanschluss (120) über eine zweite Diode (123) in Durchlassrichtung mit dem Anschluss des zweiten Kondensators (124) verbunden ist.

3. Halbbrücke nach Anspruch2, wobei das zweite Schaltelement (121) ein MOSFET ist.

4. Halbbrücke nach einem der Ansprüche 2 bis 3, wobei das zweite Ansteuerelement (122) ein Verstärker-Element ist.

5. Halbbrücke nach einem der vorstehenden Ansprüche, wobei die Halbbrücke ein drittes Ansteuerelement (132) umfasst, wobei ein erster Messanschluss des dritten Ansteuerelements (132) mit dem positiven Gleichspannungsanschluss (120) und ein zweiter Messanschluss des dritten Ansteuerelements (132) mit dem Masseanschluss (130) verbunden, wobei das dritte Ansteuerelement (132) mit dem ersten Schaltelement (111) verbunden ist und dazu eingerichtet ist, das erste Schaltelement (111) zu schließen, wenn die Spannung zwischen dem ersten Messanschluss und dem zweiten Messanschluss einen Schwellenwert überschreitet.

6. Halbbrücke nach Anspruch 5, wobei der Anschluss des ersten Kondensators (114) mit einem Spannungsversorgungsanschluss des dritten Ansteuerelements (132) verbunden ist.

7. Halbbrücke nach einem der Ansprüche 5 bis 6, wobei das dritte Ansteuerelement (132) ein Hysterese-Element ist.

8. Halbbrücke nach einem der vorstehenden Ansprüche, wobei das erste Schaltelement (111) ein MOSFET ist.

9. Halbbrücke nach einem der vorstehenden Ansprüche, wobei das erste Ansteuerelement (112) ein Verstärker-Element ist.

## Claims

1. Half-bridge for an active rectifier having an AC voltage terminal (110), a positive DC voltage terminal (120) and a ground terminal (130),
wherein a first switching element (111) connects the AC voltage terminal (110) to the ground terminal (130);
wherein a second switching element (121) connects the AC voltage terminal (110) to the positive DC voltage terminal (120),
wherein a first control element (112) for switching the first switching element (111) is connected to the first switching element (111);
wherein a terminal of a first capacitor (114) is connected to a power supply terminal of the first control element (112);
**characterised in that**
the positive DC voltage terminal (120) is connected to the terminal of the first capacitor (114) via a first diode (113) in the forward direction;
wherein the series connection of the first capacitor (114) and the first diode (113) is connected in parallel with the series connection of the first switching element (111) and the second switching element (121).

2. The half-bridge according to claim 1, wherein a second control element (122) for switching the second switching element (121) is connected to the second switching element (121); wherein a terminal of a second capacitor (124) is connected to a voltage supply terminal of the second control element (122); wherein the positive DC voltage terminal (120) is connected to the terminal of the second capacitor (124) via a second diode (123) in the forward direction.

3. The half-bridge according to claim 2, wherein the second switching element (121) is a MOSFET.

4. The half-bridge according to any one of claims 2 to 3, wherein the second control element (122) is an amplifier element.

5. The half-bridge according to any one of the preceding claims, the half-bridge comprising a third control element (132), wherein a first measurement terminal of the third control element (132) is connected to the positive DC voltage terminal (120) and a second measurement terminal of the third control element (132) is connected to the ground terminal (130), wherein the third control element (132) is connected to the first switching element (111) and is configured to close the first switching element (111) when the voltage between the first measurement terminal and the second measurement terminal exceeds a threshold value.

6. The half-bridge according to claim 5, wherein the terminal of the first capacitor (114) is connected to a power supply terminal of the third control element (132).

7. The half-bridge according to any one of claims 5 to 6, wherein the third control element (132) is a hysteresis element.

8. The half-bridge according to any one of the preceding claims, wherein the first switching element (111) is a MOSFET.

9. The half-bridge according to any one of the preceding claims, wherein the first control element (112) is an amplifier element.

## Revendications

1. Demi-pont pour un redresseur actif comportant une borne de tension alternative (110), une borne de tension continue positive (120) ainsi qu'une borne de masse (130),
dans lequel un premier élément de commutation (111) relie la borne de tension alternative (110) à la borne de masse (130) ;
dans lequel un second élément de commutation (121) relie la borne de tension alternative (110) à la borne de tension continue positive (120),
dans lequel un premier élément de commande (112) est relié au premier élément de commutation (111) pour commuter le premier élément de commutation (111) ;
dans lequel une borne d'un premier condensateur (114) est reliée à une borne d'alimentation en tension du premier élément de commande (112) ;
**caractérisé en ce que**
la borne de tension continue positive (120) est reliée à la borne du premier condensateur (114) par l'intermédiaire d'une première diode (113) dans le sens direct ;
dans lequel le montage en série constitué du premier condensateur (114) et de la première diode (113) est branché en parallèle avec le montage en série du premier élément de commutation (111) et du second élément de commutation (121).

2. Demi-pont selon la revendication 1, dans lequel un deuxième élément de commande (122) est relié au second élément de commutation (121) pour commuter le second élément de commutation (121) ; dans lequel une borne d'un second condensateur (124) est reliée à une borne d'alimentation en tension du deuxième élément de commande (122) ; dans lequel la borne de tension continue positive (120) est reliée à la borne du second condensateur (124) par l'intermédiaire d'une seconde diode (123) dans le sens direct.

3. Demi-pont selon la revendication 2, dans lequel le second élément de commutation (121) est un MOSFET.

4. Demi-pont selon l'une des revendications 2 à 3, dans lequel le second élément de commande (122) est un élément amplificateur.

5. Demi-pont selon l'une des revendications précédentes, dans lequel le demi-pont comprend un troisième élément de commande (132), dans lequel une première borne de mesure du troisième élément de commande (132) est reliée à la borne de tension continue positive (120) et une seconde borne de mesure du troisième élément de commande (132) est reliée à la borne de masse (130), dans lequel le troisième élément de commande (132) est relié au premier élément de commutation (111) et est conçu pour fermer le premier élément de commutation (111) lorsque la tension entre la première borne de mesure et la seconde borne de mesure franchit une valeur de seuil.

6. Demi-pont selon la revendication 5, dans lequel la borne du premier condensateur (114) est reliée à une borne d'alimentation en tension du troisième élément de commande (132).

7. Demi-pont selon l'une des revendications 5 à 6, dans lequel le troisième élément de commande (132) est un élément d'hystérésis.

8. Demi-pont selon l'une des revendications précédentes, dans lequel le premier élément de commutation (111) est un MOSFET.

9. Demi-pont selon l'une des revendications précédentes, dans lequel le premier élément de commande (112) est un élément amplificateur.
